(19) **Europäisches Patentamt / European Patent Office / Office européen des brevets**

(11) **EP 2 175 485 B1**

(12) **FASCICULE DE BREVET EUROPEEN**

(45) Date de publication et mention
de la délivrance du brevet:
**08.11.2017 Bulletin 2017/45**

(51) Int Cl.:
*H01L 21/60* *(2006.01)*   *H01L 23/485* *(2006.01)*
*H05K 3/34* *(2006.01)*   *H05K 3/40* *(2006.01)*

(21) Numéro de dépôt: **09305859.2**

(22) Date de dépôt: **17.09.2009**

(54) **Connexion par emboitement de deux inserts soudés et sa méthode de fabrication**

Lötverbindung zwischen zwei ineinandergreifenden Steckern, und Verfahren zur deren Herstellung

Connection between two plugged and soldered inserts and method of manufacturing the same

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **25.09.2008 FR 0856465**

(43) Date de publication de la demande:
**14.04.2010 Bulletin 2010/15**

(73) Titulaire: **Commissariat à l'Énergie Atomique et aux Énergies Alternatives
75015 Paris (FR)**

(72) Inventeur: **Marion, François
38950 SAINT MARTIN LE VINOUX (FR)**

(74) Mandataire: **Cabinet Laurent & Charras
Le Contemporain
50 Chemin de la Bruyère
69574 Dardilly Cedex (FR)**

(56) Documents cités:
**US-A- 5 056 216**   **US-A1- 2004 197 979**
**US-A1- 2006 220 198**   **US-A1- 2007 148 817**
**US-A1- 2008 135 134**   **US-B1- 6 352 881**

Printed by Jouve, 75001 PARIS (FR)

**Description**

**DOMAINE DE L'INVENTION**

Le domaine technique auquel se rapporte l'invention est celui de la microélectronique, et plus spécifiquement celui de la fabrication et de la connexion verticale (mieux connues sous l'expression « *flip-chip* ») de deux composants.

La présente invention peut être appliquée à toutes sortes de dispositifs requérant des interconnexions de type « flip chip », particulièrement à très petit pas, comme c'est le cas pour la fabrication d'imageurs de très grande dimension à très petits pas.

Il est proposé d'établir la connexion en emboîtant un insert dans un insert creux, puis en réalisant une soudure entre les deux inserts.

**ETAT ANTERIEUR DE LA TECHNIQUE**

Actuellement, il existe essentiellement deux possibilités pour assembler deux composants nécessitant un grand nombre de liaisons électriques verticales à très petit pas selon la technique « flip chip » par thermocompression :

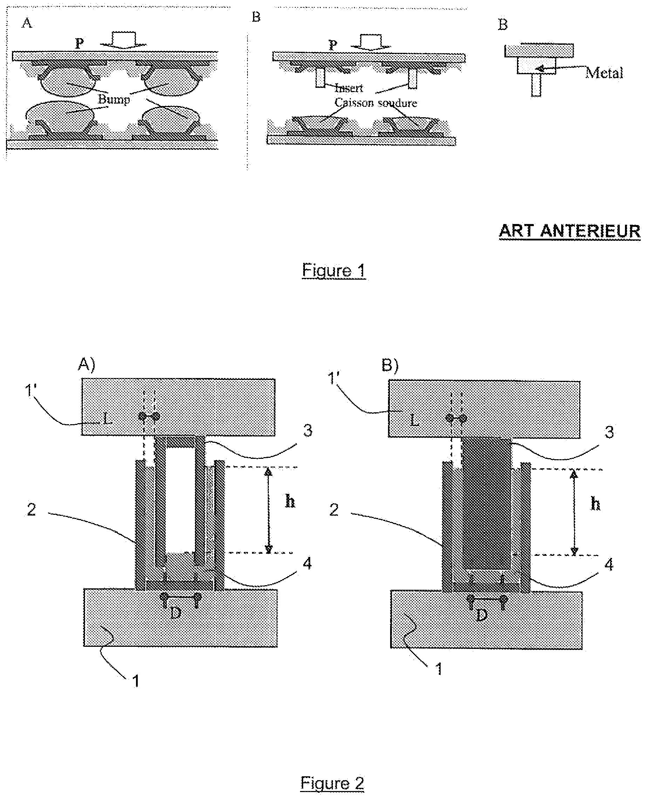

- la première technique de thermocompression consiste à presser, en température, deux billes l'une sur l'autre de manière à les lier par déformation plastique (Fig. 1A) ;
- la seconde technique, développée pour les pas d'interconnexion les plus fins, permet de travailler à une température plus basse que les températures mises en oeuvre dans la première technique : il s'agit de remplacer l'une des billes thermocompressées par une protubérance « dure » qui pénètre dans la bille de soudure en regard et casse son oxyde natif de surface pour obtenir un contact électrique, ce procédé fonctionnant à basse température. Ainsi, cette seconde technique permet :

  ▪ de réduire la température d'assemblage et la pression d'assemblage ;
  ▪ de contrôler l'écrasement : il n'y a pas de déformation plastique bille sur bille difficilement contrôlable.

Cette seconde technique, illustrée à la figure 1B, est illustrée dans le document WO2006/054005 et des inserts adaptés sont décrits dans le document US 6,179,198.

La présente invention s'inscrit dans le cadre de cette deuxième technique, appelée thermocompression par insertion, et tend à résoudre les limitations qui y sont liées, essentiellement au nombre de deux.

Le premier problème est lié aux forces de thermocompression. En effet, la section de l'insert dans le plan (X, Y) est souhaitée la plus faible possible de manière à limiter la force d'insertion.

Si le nombre de colonnes à insérer augmente, la force d'insertion à exercer sur la pièce à assembler est proportionnelle au nombre $\underline{N}$ de connexions à réaliser, ainsi qu'à la surface de leur section S, selon la formule suivante :

$$F_{hyb}= k*S*N$$

De ce fait, cette technique est limitée pour les composants à très grand nombre de connexions, sachant par exemple qu'une force de 4 tonnes devrait être envisagée pour réaliser l'hybridation d'une matrice de 4 millions de pixels (1 g/bump).

Le problème lié à ces forces peut être exacerbé en raison de la sensibilité des composants assemblés. Ainsi, certains matériaux à assembler sont très sensibles aux contraintes locales, ce qui entraîne la création de dislocations destructrices lors de l'hybridation par thermocompression.

Alternativement, les forces mises en jeu ne sont plus compatibles avec les précisions d'assemblage requises. En effet, le déplacement maximal latéral requis après hybridation doit être inférieur à 1 micromètre.

Le deuxième problème technique important soulevé par la technique de thermocompression par insertion est lié au mode de réalisation des inserts.

En effet, la réalisation de protubérances dans une fonderie semiconducteur peut devenir un problème pour des pas très réduits. Si l'on réduit la section des inserts, les techniques classiques de réalisation peuvent s'avérer difficiles à mettre en oeuvre, de par la finesse des inserts souhaités. Cette limitation est donc liée à la notion de finesse minimale de photolithogravure. Ainsi, il n'est pas possible de réduire la section d'un insert classique plein, pour une résolution photolithographique technologique donnée $\underline{D}$, en deçà de la valeur $\pi*D^2/4$.

**EXPOSE DE L'INVENTION**

Ayant analysé l'ensemble de ces contraintes spécifiques, il est proposé une solution technique particulière basée sur les éléments suivants :

- un élément de soudure assurant parfaitement le joint tube/tube ou tube/cylindre ;
- l'utilisation des propriétés de capillarités particulières des soudures.

Ainsi et selon un premier aspect, la présente invention concerne un dispositif de connexion entre deux composants constitué d'un insert conducteur creux, dans lequel est emboîté un autre insert conducteur, la connexion électrique entre les deux inserts étant assurée à l'aide d'un élément de soudure.

Le premier insert conducteur se trouve donc à la surface du premier composant à connecter. Il s'agit d'un élément creux, de type femelle, apte à recevoir un autre insert conducteur, situé quant à lui à la surface du second composant à connecter.

Ce premier élément conducteur, assimilable à un tube, peut aussi bien présenter une section annulaire (notamment ronde ou ovale) que parallélépipédique (en particulier carré ou rectangle).

Le second insert conducteur (pièce mâle) présente donc des dimensions strictement inférieures au premier (pièce femelle), de sorte à pouvoir y être emboîté convenablement. Il peut être plein (assimilable à une colonne ou cylindre plein) ou creux (assimilable à un tube). De manière avantageuse, il s'agit d'un insert creux.

Ces deux inserts sont avantageusement réalisés à base de métal pour assurer leur fonction de conduction électrique. Il s'agit par exemple de Cu, W, Pd, Ti, WSi, WN.

De manière remarquable selon l'invention, le dispositif de connexion comprend en outre un matériau de soudure, conducteur électrique, en contact simultanément avec les deux inserts et assurant ainsi leur connexion à la fois mécanique et électrique. Cet élément permet notamment de faire un joint électrique parfait entre les deux inserts soudés.

Pour réaliser ce joint, les surfaces internes et externes, respectivement, des inserts en regard sont remplies avec un matériau de soudure.

En pratique, le matériau de soudure peut être déposé au niveau des parois internes de l'insert creux au moment de sa fabrication. Alternativement, l'insert creux est doté d'un réservoir de soudure en son fond.

Grâce aux propriétés de capillarité des soudures en fusion et dans le cas où l'insert emboîté est creux, le niveau de la soudure située entre les deux inserts peut être avantageusement plus haut que le niveau la soudure située dans cet insert creux.

En effet et comme il est bien connu de l'homme du métier (K. Wassink, Soldering in electronics, 2nd ed Electrochemical Pub Limited, pp 37-61, *Wetting of surfaces*)*,* un liquide placé dans un tube de diamètre D remontera d'une hauteur K/D dans la colonne. Selon le même principe, une soudure placée entre deux parois parallèles, séparées d'une distance L, remontera d'une hauteur K'/L entre les parois. K et K' sont fonction des propriétés des surfaces en jeu (rugosité, propriétés de surface, possibilité de création d'intermétalliques pendant la soudure : même référence pp149-170).

En jouant sur l'ensemble de ces propriétés (tension de surface, mouillabilité des surfaces), et plus particulièrement en concevant un dispositif dans lequel L << D, on peut aisément faire en sorte que le volume de soudure mis à disposition dans le fond du tube femelle remonte essentiellement entre l'espace réduit compris entre les deux tubes. De la sorte, cet espace est comblé, par exemple à la manière des soudures classiques cuivre/cuivre pratiquées macroscopiquement dans la plomberie (soudure au chalumeau de tuyaux préinsérés avec apport de soudure).

En pratique et comme déjà dit, la distance L séparant les parois latérales des deux inserts est avantageusement non nulle, pour assurer un emboîtement correct d'une part et pour permettre que le matériau de soudure remonte entre les deux inserts d'autre part.

Par ailleurs et de manière avantageuse en présence d'inserts creux, la longueur ou le diamètre D de l'insert emboîté est très supérieur à la distance L séparant les parois des deux inserts. Ceci implique, comme condition avantageuse supplémentaire, que les inserts présentent des parois parallèles. Ainsi, l'élément de soudure remonte essentiellement dans l'espace ménagé entre les parois des deux inserts.

Un autre aspect de l'invention concerne le procédé de connexion à proprement parler entre les deux composants.

Ce procédé présente un avantage considérable : la mise en regard des deux inserts à connecter peut se faire à force nulle.

En pratique, ce procédé peut être décomposé en deux étapes :

> Une machine de positionnement « *pick and place* » standard pré-insère les composants, avant soudure. Les pièces insérées peuvent alors être déplacées sans risque de désalignement, avant la soudure par refusion.

Ensuite, l'étape de soudure par refusion à proprement parler est mise en oeuvre. Elle peut être réalisée à l'aide d'un four de refusion.

A l'issue de ce procédé, on obtient un élément de connexion entre composants conforme à celui décrit ci-dessus.

Dans un mode de réalisation particulier, une couche de colle est déposée avant emboîtement sur la surface d'au moins l'un des composants, entre les inserts. Dans le cas où la couche sacrificielle du composant doté d'inserts femelles est conservée, ceci permet encore d'améliorer la stabilité de la connexion.

## BREVE DESCRIPTION DES FIGURES

La manière dont l'invention peut être réalisée et les avantages qui en découlent ressortiront mieux de l'exemple de réalisation qui suit, donné à titre indicatif et non limitatif, à l'appui des figures annexées parmi lesquelles :

> La figure 1 illustre les différents systèmes de connexion substrat/puce selon l'art antérieur.
> La figure 2 schématise un dispositif de connexion comprenant un insert creux dans lequel est emboîté un second insert, lui-même creux (A) ou plein (B), les deux inserts étant en contact via un élément de soudure. La figure 2A schématise un dispositif de connexion selon l'invention. La figure 3 schématise l'hybridation de deux composants via l'insertion d'un tube dans un autre tube contenant un matériau de soudure.

La figure 4 schématise les différentes étapes de fabrication d'un composant doté d'inserts « femelles » selon l'invention.

La figure 5 représente une vue en section d'un composant doté à sa surface de protubérances pleines ayant la forme de cylindres.

La figure 6 détaille l'un procédé alternatif d'hybridation entre deux composants.

La figure 7 détaille un procédé alternatif d'hybridation impliquant la conservation d'une couche « sacrificielle » et un renfort par collage.

## MODES DE REALISATION DE L'INVENTION

L'obtention d'un élément de connexion faisant l'objet de l'invention, ainsi que la mise en oeuvre du procédé d'hybridation entre deux composants selon l'invention, requièrent la fabrication de protubérances (également appelées inserts) destinées à la connexion. Celles-ci sont situées à la surface des composants d'intérêt à connecter électriquement.

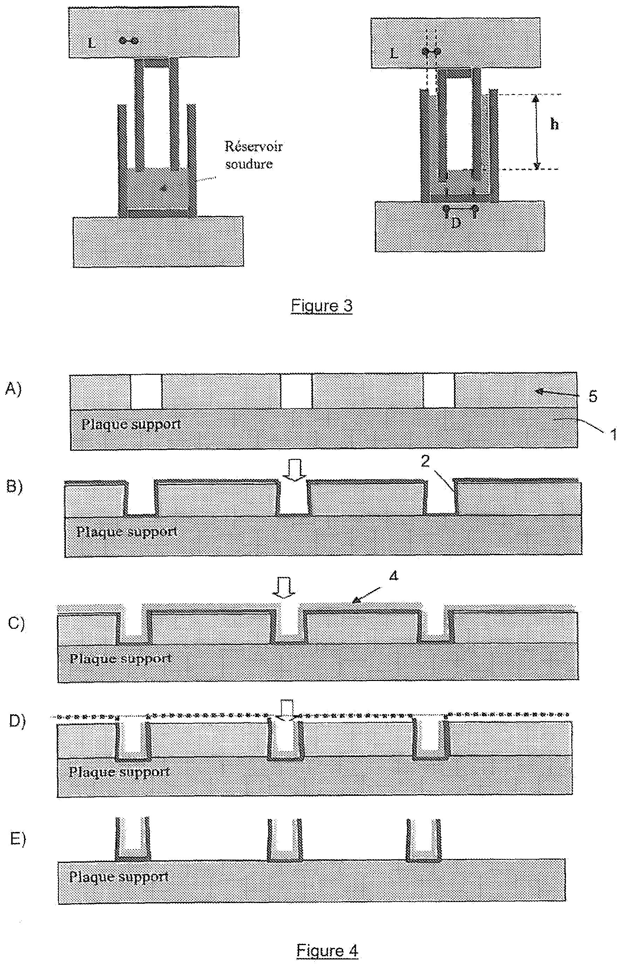

Un composant doté d'inserts, conforme à la présente invention, peut être obtenu à l'aide du procédé illustré à la figure 4. Il s'agit typiquement d'un wafer CMOS (« *metal-oxide semiconductor* ») issu d'une fonderie silicium, d'un boîtier céramique ou autre.

La figure 4 illustre plus avant la fabrication d'inserts ou protubérances sous forme de tube femelle, dont les parois internes sont à base de métal et recouvertes d'un matériau de soudure.

La première étape (Fig. 4A) consiste à déposer, sur le composant destiné à être connecté (1), une couche dite « sacrificielle », d'épaisseur $e_1$ et réalisée à l'aide d'une résine (5). Cette couche est ensuite soumise à une photolithographie standard. Cette étape permet de créer des ouvertures du diamètre souhaité pour les tubes qui serviront d'inserts (2). Plus généralement, c'est lors de cette étape que la future forme de l'insert est fixée (hauteur, forme de l'ouverture...).

La seconde étape (Fig. 4B) correspond au dépôt du métal, éventuellement une multicouche de métal, correspondant au tube. C'est l'épaisseur de ce dépôt qui dictera l'épaisseur $e$ de l'insert creux. Le métal est par exemple choisi dans le groupe comprenant : Cu, W, Pd, Ti, WSi, WN.

Les diamètres d'ouverture sont maîtrisables à des valeurs inférieures à 1 micromètre et les hauteurs supérieures à 3 micromètres.

Les épaisseurs des métaux sont réglables et contrôlées jusqu'à des valeurs inférieures à 0,1 micromètre.

Il est possible de modifier, ou simplement compléter le dépôt métal habituel par une couche complémentaire d'un métal mouillable, avantageusement de l'or, du platine ou du cuivre. Ceci a pour avantage de faciliter la soudure ultérieure et la création des interfaces intermétalliques nécessaires lors de la soudure finale.

Dans un mode de réalisation privilégiée, l'insert creux prend une forme finale de «tube », correspondant à une ouverture circulaire. Toutefois, toute autre forme peut être réalisée par une conception adaptée du masque d'ouverture : triangle, carré, polygone, ...

Il est également possible de combiner des formes différentes sur une même plaque de fabrication et/ou sur une même puce à hybrider.

La troisième étape (Fig. 4C) consiste à déposer un matériau de soudure (4) à l'intérieur du tube, sur ses parois internes. Ce matériau de soudure est choisi parmi les matériaux classiquement utilisés, permettant un assemblage fiable : ils n'entraînent pas de formation de « voids » et sont résistants à l'électromigration, ont une bonne durée de vie, ne présentent pas de vieillissement prématuré et sont résistants au cyclage thermique. Il s'agit typiquement de l'indium (In), de $In_xSn_y$, de $Au_xSn_y$, ou de $Cu_xAg_ySn_z$. En pratique, le dépôt du matériau de soudure est réalisé en suivant le dépôt métallique réalisé lors de l'étape précédente (Fig. 4B).

La quatrième étape (Fig. 4D) consiste à retirer la couche de métal, ainsi que celle de soudure, situées sur le plan supérieur de la résine martyre. Deux techniques de gravure, bien connues de l'homme du métier, peuvent être mises en oeuvre : la technique de « gravure damascène » ou le procédé « gap fill ».

La dernière étape (Fig. 4E), qui est une étape optionnelle, correspond au retrait de la couche martyre (5). Il s'agit d'une étape parfaitement connue de délaquage.

Un tel insert creux femelle est par exemple illustré à la figure 2.

Il apparaît clairement à l'homme du métier que l'insert mâle, destiné à être emboîté dans l'insert femelle décrit ci-dessus, peut être obtenu à l'aide d'un procédé similaire, à quelques modifications près :

- l'insert mâle présente une section de dimension inférieure à celle de l'insert creux femelle dans lequel il est destiné à être inséré ou emboîté ;

- l'insert mâle est dépourvu de matériau de soudure, au moins sur ses parois internes ;

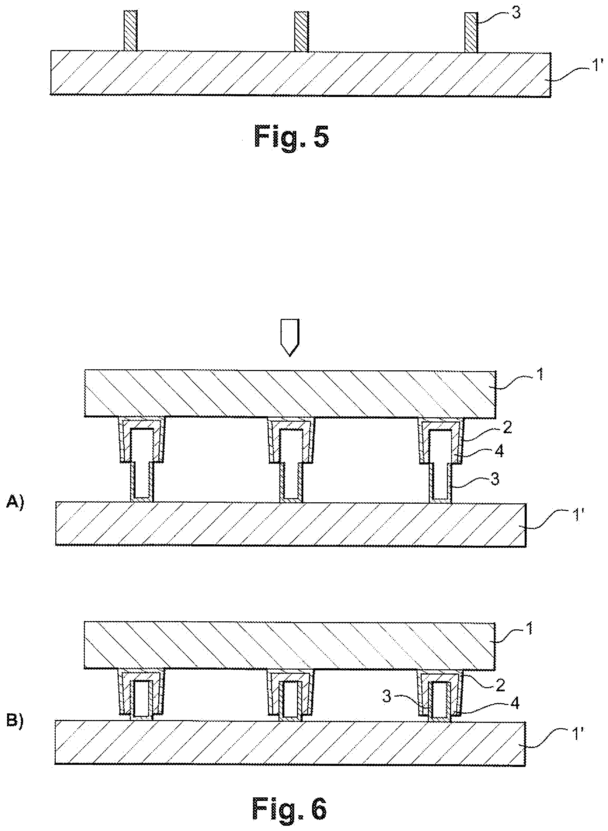

- selon un exemple alternatif à l'invention, l'insert mâle peut prendre la forme d'un cylindre ou d'un parallélépipède plein. Pour cela, lors de l'étape de dépôt du métal (Fig. 4B), les cavités générées dans la couche martyre par photolithographie (Fig. 4A) doivent être entièrement remplies de métal, sans laisser de vide. Par ailleurs, l'homme de l'art peut aisément réaliser des cylindres, en utilisant des techniques de croissance électrolytique largement décrites dans la littérature (voir par exemple P.C. Andricacos et al., IBM Journal of Research and Development, 1998, 42(5), pp 567-74, *Damascene copper electroplating for chip interconnections*). Une telle forme en cylindre pour l'insert mâle est schématisée à la figure 5.

Les composants dotés de tels inserts peuvent alors être connectés lors du procédé d'hybridation détaillé ci-après.

Un premier procédé est schématisé à la figure 3 en rapport avec deux inserts creux, l'insert femelle possédant un réservoir de soudure.

La figure 6 détaille plus avant un procédé d'hybridation selon l'invention :

Dans une première étape (Fig. 6A), les inserts femelles, dont les parois internes sont recouvertes du matériau de soudure, sont placés en vis-à-vis des inserts mâles. Ensuite, le poids de la puce supérieure est suffisant pour emboîter les inserts en regard. Si besoin, une légère pression est exercée pour réaliser l'emboîtement.

Après insertion à force quasi nulle, on obtient deux composants connectés électriquement à l'aide d'un dispositif de connexion selon l'invention (Fig. 6B).

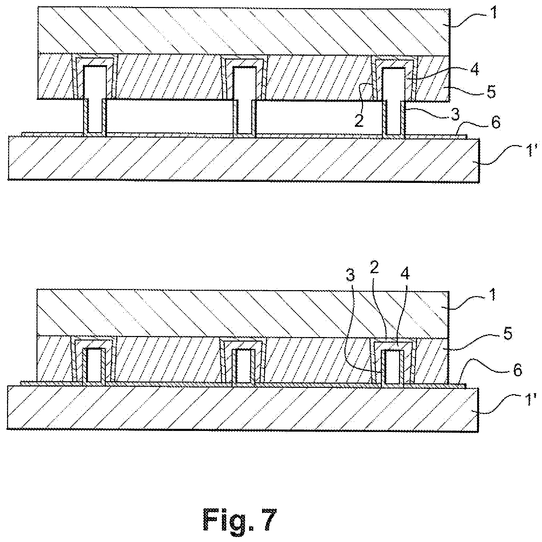

Un procédé d'hybridation plus élaboré est illustré à la figure 7. Dans ce cas de figure, la couche dite « sacrificielle » (5) présente sur le composant doté d'inserts femelles est réalisée à l'aide d'un matériau pérenne. En d'autres termes, l'étape de la Figure 4E n'est pas mise en oeuvre et la couche sacrificielle est conservée à l'issue de la fabrication des inserts femelles remplis de soudure.

La surface du composant qui est situé en regard de la couche sacrificielle peut, avant ou après l'insertion, être recouverte d'une couche de colle (6). La connexion entre les deux composants, et donc la structure finale, se trouve ainsi consolidée, comme schématisé à la figure 7.

Les avantages de la présente invention ressortent clairement de la présente demande :

- la mise en regard des composants à joindre peut être réalisée à force nulle, contrairement aux procédés de l'art antérieur ;
- Le procédé d'hybridation ne comprend que deux étapes : une étape de pré-insertion avant soudure, au cours de laquelle les composants peuvent être déplacés sans risque de désalignement, puis une étape de soudure par refusion permettant de refondre simultanément plusieurs éléments pré-insérés ;
- le contact entre les inserts est ainsi assuré par une liaison métallurgique de type soudure ;
- la surface de contact entre les deux inserts est maximisée par rapport au volume de soudure mis en jeu. Il est possible d'envisager de pomper la soudure dans un « réservoir de soudure », situé au fond du tube femelle.

Ceci permet de réaliser des inserts de très grand rapport de forme inscrits dans des pas d'interconnexion très fins, tout en utilisant des technologies parfaitement maîtrisées dans l'industrie du semi conducteur.

La technique proposée permet notamment de multiplier le nombre de points hybridés à force d'insertion constante. En parallèle, la résistance d'accès pixel est améliorée, typiquement d'un facteur 2 pour la même limite de résolution photolithographique.

La présente invention trouve de nombreuses applications, notamment :

- pour les matrices de détection hétérogènes, de grande taille, à grand nombre de connexions par insertion (IRCMOS CMT refroidis, détecteurs X, etc...) ;

- pour les matrices sensibles à la température hybridées à « froid » ;

- pour les matrices sensibles aux contraintes mécaniques ;

- comme méthode d'interconnexion strate à strate pour les empilements 3D Si-CMOS (empilement Tamb 0 Force + recuit collectif 0 Force du stack constitué) : l'empilement se fait à température ambiante, chaque strate est posée sans le besoin d'exercer une force, et c'est un recuit collectif de l'empilement qui est réalisé. Ainsi, chaque puce ne subit qu'un seul cycle thermique de soudure, ce qui évite la fragilisation des interfaces et des barrières de diffusion ;

- pour les connexions MEMS (« *Micro Electro Mechanical Systems* ») sur CMOS sensibles aux contraintes thermiques et force.

## Revendications

1. Dispositif de connexion entre deux composants de la microélectronique (1, 1'), comprenant un insert conducteur creux (2) situé à la surface du premier composant (1) dans lequel est emboîté un autre insert conducteur creux (3) situé à la surface du second composant (1'), selon lequel :

   • la connexion électrique entre les deux inserts creux (2, 3) est assurée à l'aide d'un élément de soudure (4) ; et
   • la longueur ou le diamètre (D) de l'insert emboîté (3) est très supérieur à la distance (L) non nulle entre les parois des deux inserts (2, 3) de sorte que le niveau du matériau de soudure (4) à l'intérieur de l'insert emboîté (3) est inférieur à celui entre les deux inserts (2, 3).

2. Dispositif de connexion selon la revendication 1, *caractérisé* **en ce que** l'insert conducteur creux (2) présente une section annulaire, notamment ronde ou ovale, ou parallélépipédique, en particulier carré ou rectangle.

3. Dispositif de connexion selon l'une des revendications précédentes, *caractérisé* **en ce que** l'élément de soudure (4) est un matériau conducteur électrique, en contact avec les deux inserts (2, 3).

4. Procédé d'hybridation entre deux composants de la microélectronique, l'un (1) étant doté à sa surface d'inserts conducteurs creux (2) et l'autre (1') étant doté à sa surface d'inserts conducteurs creux (3) susceptibles de s'emboîter dans les inserts conducteurs creux (2), l'insert de type femelle (2), apte à recevoir l'autre insert (3), étant rempli de matériau de soudure (4), la longueur ou le diamètre (D) de l'insert à emboîter (3) étant très supérieur à la distance (L) non nulle entre les parois des deux inserts (2, 3), comprenant les étapes suivantes :

    - alignement et emboîtement des inserts (2, 3) ;
    - soudure par refusion.

5. Procédé d'hybridation entre deux composants selon la revendication 4, *caractérisé* **en ce que** le matériau de soudure (4) recouvre les parois internes de l'insert conducteur creux (2).

6. Procédé d'hybridation entre deux composants selon la revendication 4, *caractérisé* **en ce que** le matériau de soudure (4) est situé dans un réservoir de soudure au fond de l'insert conducteur creux (2).

7. Procédé d'hybridation entre deux composants selon l'une des revendications 4 à 6, *caractérisé* **en ce qu'**une couche de colle (6) est déposée avant emboîtement sur la surface d'au moins l'un des composants (1'), entre les inserts (3).

**Patentansprüche**

1. Verbindungsvorrichtung zwischen zwei Komponenten der Mikroelektronik (1, 1'), die einen hohlen stromführenden Stecker (2) an der Oberfläche des ersten Komponenten (1) umfasst, in welchen ein anderer hohler, stromführender Stecker (3) an der Oberfläche des zweiten Komponenten (1') eingerastet ist, gemäß dem:

    • die elektrische Verbindung zwischen den beiden hohlen Steckern (2, 3) durch ein Lötelement (4) gewährleistet wird; und
    • die Länge oder der Durchmesser (D) des eingerasteten Steckers (3) weit länger als die Entfernung (L), die ungleich Null ist, zwischen den Wänden der beiden Stecker (2, 3) ist, derart, dass die Höhe des Lötmaterials (4) im Innern des eingerasteten Steckers (3) kleiner ist, als die zwischen den beiden Steckern (2, 3).

2. Verbindungsvorrichtung gemäß Anspruch 1, **dadurch gekennzeichnet, dass** der hohle, stromführende Stecker (2) einen ringförmigen Abschnitt aufweist, der insbesondere rund, oval oder parallel oder parallelflächig, insbesondere quadratisch oder rechteckig ist.

3. Verbindungsvorrichtung gemäß einem der vorstehenden Ansprüche, **dadurch gekennzeichnet, dass** das Lötelement (4) ein stromführendes Material ist und mit den beiden Steckern (2, 3) in Kontakt steht.

4. Verfahren zur Hybridisierung zweier Komponenten der Mikroelektronik, wobei einer der Komponenten (1) an seiner Oberfläche mit stromführenden, hohlen Steckern (2) bestückt ist und der andere (1') an seiner Oberfläche mit stromführenden, hohlen Steckern (3) bestückt ist, die vorgesehen sind, in die hohlen, stromführenden Stecker (2) einzurasten, wobei die Buchse (2) geeignet ist, den anderen Stecker (3) aufzunehmen, und mit Lötmaterial (4) gefüllt ist, und wo die Länge oder der Durchmesser (D) des einzurastenden Steckers (3) sehr viel länger als die Entfernung (L), die ungleich Null ist, zwischen den Wänden der beiden Stecker (2, 3) ist, und folgende Etappen umfasst: Ausrichtung und Einrasten der Stecker (2, 3); Löten durch Umschmelzen.

5. Verfahren zur Hybridisierung zweier Komponenten gemäß Anspruch 4, **dadurch gekennzeichnet, dass** das Lötmaterial (4) die Innenwände des hohlen, stromführenden Steckers (2) bedeckt.

6. Verfahren zur Hybridisierung zweier Komponenten gemäß Anspruch 4, **dadurch gekennzeichnet, dass** sich das Lötmaterial (4) in einem Schweißbehälter am Boden des hohlen stromführenden Steckers (2) befindet.

7. Verfahren zur Hybridisierung zweier Komponenten gemäß einem der Ansprüche 4 bis 6, **dadurch gekennzeichnet, dass** eine Schicht Klebstoff (6) vor dem Einrasten auf der Oberfläche von mindestens einem der Komponenten (1') zwischen den Steckern (3) aufgebracht wird.

**Claims**

1. Connection device between two micro-electronic components (1, 1') comprising a hollow conductive insert (2) situated at the surface of the first component (1), into which is fitted another hollow conductive insert (3) situated at the surface of the second component (1'), wherein :

    • the electrical connection between the two inserts (2, 3) is provided by means of a solder element (4) ;

• the length or the diameter (D) of the fitted insert (3) is much greater than the non-null distance (L) between the walls of the two inserts (2, 3), such that the level of the solder material (4) inside the fitted insert (3) is below the level between the two inserts (2, 3).

2. Connection device as claimed in claim 1, *characterized* **in that** the hollow conductive insert (2) is of annular cross-section, particularly round or oval, or parallelepiped, in particular square or rectangular.

3. Connection device as claimed in one of the previous claims, *characterized* **in that** the solder element (4) is an electrically conductive material, in contact with the two inserts (2, 3).

4. Method for hybridizing between two micro-electronic components, one (1) being provided at its surface with hollow conductive inserts (2) and the other (1') being provided at its surface with hollow conductive inserts (3) able to be fitted into the hollow conductive inserts (2), the female insert (2) able to receive the other insert (3) being filled with solder material (4), the length or the diameter (D) of the fitted insert (3) being much greater than the non-null distance (L) between the walls of the two inserts (2, 3), comprising the following steps:

    - aligning and fitting together the inserts (2, 3);
    - reflow soldering.

5. Method for hybridizing between two components as claimed in claim 4, *characterized* **in that** the solder material (4) coats the internal walls of the hollow conductive insert (2).

6. Method for hybridizing between two components as claimed in claim 4, *characterized* **in that** the solder material (4) is found in a reservoir of solder at the bottom of the hollow conductive insert (2).

7. Method for hybridizing between two components as claimed in one of claims 4 to 6, *characterized* **in that** a layer of adhesive (6) is deposited before fitting on the surface of at least one of the components (1'), between the inserts (3).

A

P

Bump

B

P

Insert
Caisson soudure

B

Metal

ART ANTERIEUR

Figure 1

A)

1'

L

3

2

h

4

D

1

B)

1'

L

3

2

h

4

D

1

Figure 2

Figure 3

Figure 4

**Fig. 5**

**Fig. 6**

Fig. 7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2006054005 A
- US 6179198 B

**Littérature non-brevet citée dans la description**

- **K. WASSINK.** Soldering in electronics. Electrochemical Pub Limited, 37-61
- **P.C. ANDRICACOS et al.** *IBM Journal of Research and Development,* 1998, vol. 42 (5), 567-74